Europäisches Patentamt

European Patent Office

Office européen des brevets

(19)

(11) **EP 1 315 259 A1**

(12) **EUROPEAN PATENT APPLICATION**

(43) Date of publication:
**28.05.2003 Bulletin 2003/22**

(51) Int Cl.⁷: **H01S 5/0687**

(21) Application number: **01309898.3**

(22) Date of filing: **23.11.2001**

(84) Designated Contracting States:
**AT BE CH CY DE DK ES FI FR GB GR IE IT LI LU
MC NL PT SE TR**
Designated Extension States:
**AL LT LV MK RO SI**

(71) Applicant: **Agilent Technologies, Inc. (a Delaware
corporation)
Palo Alto, CA 94303 (US)**

(72) Inventor: **Harker, Andrew
Ipswich, Suffolk IP1 2JN (GB)**

(74) Representative: **Coker, David Graeme et al
Agilent Technologies UK Ltd,
Legal Dept,
Eskdale Road,
Winnersh Triangle
Wokingham, Berks RG41 5DZ (GB)**

(54) **Optical apparatus and method therefor**

(57)    A known configuration for detecting changes in wavelength of light from a laser device comprises a beam splitter for directing incident light thereupon towards a first photodiode via an optical filter and a second photodiode spaced relatively far apart from the first photodiode, thereby increasing an overall package size for the laser device in combination with a wavelength locker. The present invention overcomes this problem by disposing the first photodiode (114) adjacent the second photodiode (116) and employing an optical diffractive element (108) to direct, along distinct optical paths, light towards each of the first photodiode (114) and the second photodiode (116).

*Fig. 1*

EP 1 315 259 A1

**Description**

The present invention relates to an optical apparatus of the type used in a wavelength locker, for example of the type that generates an error signal for controlling a wavelength of a laser device. The present invention also relates to a method of detecting a change of a wavelength of electromagnetic radiation.

In a fibre-optic network, wavelength of light used to communicate a signal is an important parameter. In particular, where Wavelength Division Multiplexing (WDM) systems are employed, different signals are communicated using respectively different wavelengths. Consequently, it is important to maintain the different wavelengths accurately in relation to components of the WDM system, for example multiplexers and demultiplexers, which add or remove wavelengths from the WDM system.

Typically, a semiconductor laser device is employed in a transmitter unit of the fibre-optic network. The wavelength of light transmitted by the laser device can be accurately controlled by altering a parameter, for example temperature, of the laser device using a closed loop feedback circuit. In this example, in order to determine whether to heat or cool the laser device, and to what extent, to restore the wavelength of the laser device to a predetermined wavelength, an error signal needs to be generated in the feedback circuit.

Known apparatus for detecting changes in the wavelength of the laser device are disclosed in US 4, 309, 671, US 6, 144, 025, US 5, 825, 792. US 4, 309, 671 discloses a laser diode, a proximal beam splitting mirror and a proximal photodiode to receive light from the proximal beam splitting mirror, a distal beam splitting mirror and a distal photodiode to receive light from the distal beam splitting mirror, and a filter disposed between the distal beam splitting mirror and the distal photodiode. An electronic control circuit is also disclosed for stabilising the laser diode. When in use, a divergent beam is emitted by the laser diode. The proximal beam splitting mirror directs a proportion of the light incident upon the proximal beam splitting mirror onto the proximal photodiode.

Similarly, light passing through the proximal beam splitting mirror is incident upon the distal beam splitting mirror, the distal beam splitting mirror directing a proportion of the light incident upon the distal beam splitting mirror onto the distal photodiode. Since the light continues to diverge when propagating from the proximal beam splitting mirror to the distal beam splitting mirror, the distal photodiode only receives a small fraction of the light directed towards the distal photodiode. The provision of two beam splitting mirrors spaced apart increases the cost and size of the above apparatus. Additionally, the spacing of two beam splitting mirrors results in the proximal and distal photodiodes being unable to make efficient use of the proportions of light respectively directed towards them due to the divergent nature of the beam emitted by the laser diode.

US 5, 825, 792 discloses a relatively compact apparatus comprising a lens, a Fabry-Perot etalon and two photodiodes, the apparatus being small enough to be copackaged with a semiconductor laser in an industry standard package known as a "butterfly" package. The etalon splits light emitted by the semiconductor laser and propagates the light over multiple paths of different lengths before recombination. Respective phases are accumulated over the multiple paths, the phases accumulated being wavelength-dependent. Consequently, the result of the recombination also depends upon wavelength.

The dimensions of the etalon depend upon a required resolving power, R, of the etalon; the resolving power is a measure of a minimum change of wavelength that can be detected. The resolving power, R, of the etalon is given by the following equation:

$$R = F\frac{2nd}{\lambda_0}$$

where:

F is the coefficient of finesse,
n is the refractive index of the etalon,
$d$ is the thickness of the etalon, and
$\lambda_0$ is the wavelength of operation.

As a practical example, in order to monitor a 100 GHz or 50 GHz channel spacing, at least one dimension of the etalon has to be approximately 1 mm or approximately 2 mm, respectively. Clearly, such dimensions are large compared with a typical dimension of a semiconductor laser of approximately 300 $\mu$m.

Hence, as explained above in relation to US 4,309,671 and US 5,825,792, to copackage the semiconductor laser device with the etalon requires a package that is substantially larger than a package for the semiconductor laser device alone, since for small channel spacings the dimensions of the etalon are large. Also, the etalon of the apparatus of US 5,825,792 requires very precise angular alignment with respect to the beam emitted by the laser device.

US 6, 144, 025 discloses a laser diode coupled to a first optical fibre. When in use, light emitted by the laser diode propagates through the first optical fibre, a lens, a cut filter, after which the light is incident upon a beam splitter. A first photodiode is located on a first side of the beam splitter and a second photodiode is located on a second side of the beam splitter. An optical band-pass filter is disposed in-line between the beam splitter and the first photodiode. A proportion of the light incident upon the beam splitter is directed towards the first photodiode. A first proportion of the light directed towards the first photodiode is permitted to pass through to the first photodiode and a second proportion of the light directed towards the first photodiode is reflected by the optical band-pass filter to the second photodiode via the beam splitter. A certain proportion of the light incident upon the beam splitter via the cut filter is permitted to pass directly through the beam splitter to a lens that focuses the transmitted light into a second optical fibre.

The apparatus of US 6, 144, 025 is influenced by a requirement for an optimum beam diameter for efficient launch of light into the second optical fibre. Consequently, the optimum beam diameter may be too large for efficient collection of light by the first and second photodiodes. Additionally, the first and second photodiodes are relatively widely separated and so can not be formed as a joined pair of detectors. Also, the beam splitter and the optical band-pass filter have to be aligned with angular precision, because light incident upon the second photodiode is reflected by the beam splitter and the optical band-pass filter, and small angular errors in the position of the beam splitter and the optical band-pass filter will cause the beam to be displaced laterally at the locations of the first and second photodiodes. The first and second photodiodes of the apparatus of US 6,144,025 are separated and so are susceptible to the effects of ageing and temperature differences.

Therefore, according to a first aspect of the present invention, there is provided an optical apparatus for a wavelength deviation detection circuit comprising an optical element for generating at least three propagation paths, a first photodiode, a second photodiode and an optical wavelength discriminator disposed between the optical element and the second photodiode characterised in that the first photodiode is disposed adjacent the second photodiode and the optical element is a diffractive optical element arranged to transmit a first proportion of light propagating towards the diffractive optical element therethrough, and direct a second proportion of the light propagating towards the diffractive optical element towards the first photodiode and a third proportion of the light propagating towards the diffractive optical element towards the second photodiode.

Preferably, the first photodiode and the second photodiode are formed as a joint photodiode.

Preferably, the diffractive optical element beam shapes.

Preferably, the optical wavelength discriminator is an optical filter or etalon. Most preferably, the optical wavelength discriminator is an etalon.

According to a second aspect of the present invention, there is provided a method of generating a first signal and a second signal indicative of a change in wavelength of light, the method comprising the steps of: propagating the light towards an optical element, the optical element transmitting a first proportion of the light, the optical element directing a second proportion of the light towards a first photodiode, the optical element directing a third proportion of the light towards a second photodiode and an optical wavelength discriminator, characterised in that the light is transmitted and directed by a diffractive optical element and the first photodiode is adjacent the second photodiode.

According to a third aspect of the present invention, there is provided a use of a diffractive optical element in an optical apparatus to generate a first signal and a second signal indicative of a change in wavelength of light incident upon the diffractive optical element.

It should be appreciated that references to "light" herein refer to electromagnetic radiation of wavelengths between about 300 nm and about 10 μm, preferably between about 400 nm and about 2 μm, very preferably between about 800 nm and about 1700 nm.

It is thus possible to provide a relatively compactly packagable apparatus that can be conveniently copackaged with a laser device and that permits the use of photodiodes as joined pairs, thereby automatically compensating for ageing effects of the photodiodes and temperature differences therebetween. The use of joined pairs of photodiodes also overcoming the need for precise angular alignment of beam splitting mirrors with respect to beams reflected thereby. The sensitivity to precise location of the filter relative to the first photodiode is avoided and an optimum beam diameter can be maintained, thereby obviating compromising the optimum beam diameter on account of the use of standard, generally round, photodiodes. In addition, the geometry of the optical components forming the apparatus is not constrained by the choice of optical fibre into which light from a laser device is launched. Also, a single beam splitting diffractive optical element provides all of the above advantages. Consequently, it can be seen that fewer optical components are required to form the apparatus, resulting in reduced costs and improved ease of assembly.

At least one embodiment of the invention will now be described, by way of example only, with reference to the accompanying drawings in which:-

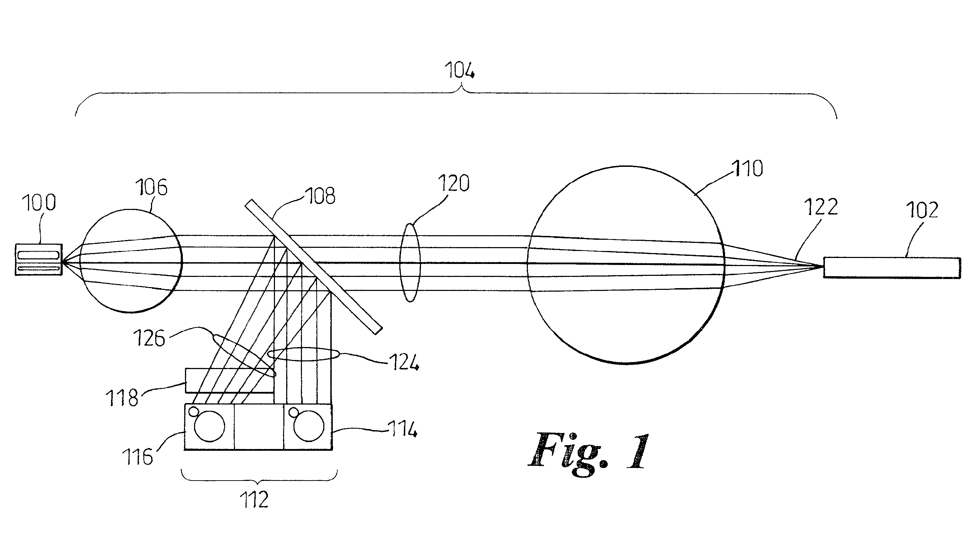

**Figure 1** is a schematic diagram of an apparatus constituting an embodiment of the present invention.

Referring to Figure 1, a laser device, for example a semiconductor laser diode 100 is arranged to launch light emitted by the laser diode 100 into an optical fibre 102. An optical apparatus 104 is disposed between the laser diode 100 and the optical fibre 102. The optical apparatus 104 comprises a collimating lens 106 disposed adjacent the laser diode 100 and in a first, straight, optical path between the laser diode 100 and the first optical fibre 102. A diffractive optical element 108 is disposed adjacent the collimating lens 106 and also in the first optical path between the laser diode 100 and the optical fibre 102. A focussing lens 110 is disposed between the diffractive optical element 108 and the optical fibre 102.

To one side of the first optical path, a dual photodiode 112 is disposed. The dual photodiode 112 comprises a first photodiode 114 disposed adjacent a second photodiode 116. The first photodiode 114 is disposed so as to be in a second optical path, the second optical path being, not essentially, perpendicular to the first optical path. The second photodiode 116 adjacent the first photodiode 114 is disposed parallel to the first optical path and in a third optical path, the third optical path being at a non-perpendicular angle to the first optical path. A wavelength discriminator, for example an edge filter or etalon, 118 is disposed adjacent the second photodiode 116 and in the third optical path.

In operation, light emitted by the laser diode 100 follows the first optical path and is collimated by the collimating lens 106 before propagating towards the diffractive optical element 108. Upon incidence upon the diffractive optical element 108, a first proportion 120 of the light emitted by the laser diode 100 is permitted to propagate through the diffractive optical element 108 so as to continue following the first optical path towards the focussing lens 110 where the first proportion of the light brought to a focus 122 and launched into the optical fibre 102.

Additionally, upon incidence upon the diffractive optical element 108, a second proportion 124 of the light emitted by the laser diode 100 is directed towards the first photodiode 124 along the second optical path. A third proportion 126 of the light emitted by the laser diode 100 is directed along the third optical path towards the second photodiode 116.

Depending upon the wavelength of the light emitted by the laser diode 100, a first proportion of the third proportion 126 of the light emitted by the laser diode 100 is permitted to transmit through the wavelength discriminator 118 towards the second photodiode 116.

Using an output ratio calculator unit (not shown) coupled to the first and second photodiodes 114, 116, for example as described in US 6, 144, 025, an error signal can be generated from signals generated by the first and second photodiodes 114, 116. The error signal can be used by a driver circuit (not shown) for the laser diode 100, for example, a Proportional Integral Differential (PID) controller to influence the generation of light by the laser diode 100 so as to ensure that the wavelength of the light generated by the laser diode 100 remains substantially at a required wavelength. Examples of influencing the generation of light by the laser diode 100 includes controlling the temperature of the laser diode 100, or where more than one current is applied to the laser diode 100, controlling one or more of those currents.

**Claims**

1. An optical apparatus (104) for a wavelength deviation detection circuit comprising an optical element for generating at least three propagation paths, a first photodiode (114), a second photodiode (116) and an optical wavelength discriminator (118) disposed between the optical element and the second photodiode (116) **characterised in that** the first photodiode (114) is disposed adjacent the second photodiode (116) and the optical element is a diffractive optical element (108) arranged to transmit a first proportion (120) of light propagating towards the diffractive optical element (108) therethrough, and direct a second proportion (124) of the light propagating towards the diffractive optical element (108) towards the first photodiode (114) and a third proportion (126) of the light propagating towards the diffractive optical element (108) towards the second photodiode (116).

2. An apparatus as claimed in Claim 1, wherein the first photodiode (114) and the second photodiode (116) are formed as a joint photodiode.

3. An apparatus as claimed in Claim 1 or Claim 2, wherein the diffractive optical element (108) beam shapes.

4. An apparatus as claimed in any one of Claims 1 to 3, wherein the optical wavelength discriminator (118) is an optical filter.

5. An apparatus as claimed in any one of Claims 1 to 3, wherein the optical wavelength discriminator (118) is an etalon.

6. A method of generating a first signal and a second signal indicative of a change in a wavelength of light, the method comprising the steps of:

   propagating the light towards an optical element,
   the optical element transmitting a first proportion of the light,
   the optical element directing a second proportion of the light towards a first photodiode (114),
   the optical element directing a third proportion of the light towards a second photodiode (116) and an optical wavelength discriminator (118),

   **characterised in that** the light is transmitted and directed by a diffractive optical element (108) and the first photodiode (114) is adjacent the second photodiode (116).

7. Use of a diffractive optical element (108) in an optical apparatus to generate a first signal and a second signal indicative of a change in wavelength of light incident upon the diffractive optical element (108).

**Fig. 1**

EP 1 315 259 A1

**European Patent Office**

# EUROPEAN SEARCH REPORT

**Application Number**

EP 01 30 9898

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | WO 01 77626 A (DIGITAL OPTICS CORP ;FELDMAN MICHAEL R (US); HAN HONGTAO (US); HAM) 18 October 2001 (2001-10-18) | 1,3-5,7 | H01S5/0687 |
| Y | * page 6, paragraph 1 - page 11, paragraph 1 *<br>* figure 2 * | 2,6 | |
| Y | EP 0 911 621 A (FUJITSU LTD) 28 April 1999 (1999-04-28)<br>* column 4, line 14 - line 43 *<br>* column 7, line 51 - column 8, line 37 *<br>* figure 4 * | 2,6 | |
| X | WO 99 04466 A (CHANEY RAYMOND JOHN ;COPNER NIGEL JOSEPH (GB); RENISHAW PLC (GB)) 28 January 1999 (1999-01-28) | 7 | |
| A | * page 3, paragraph 3 - page 5 *<br>* figures 3,4 * | 1,6 | |
| X | DE 44 29 748 A (FAGOR S COOP LTDA) 16 March 1995 (1995-03-16) | 7 | |
| A | * column 4, line 42 - column 5, line 12 *<br>* figure 4 * | 1,6 | |
| A | GB 2 353 858 A (BOOKHAM TECHNOLOGY LTD ;BOOKHAM TECHNOLOGY PLC (GB)) 7 March 2001 (2001-03-07)<br>* page 5, paragraph 2 - page 8, paragraph 2 *<br>* figure 7 * | 1,6,7 | |
| D,A | US 5 825 792 A (KIM HYUNG B  ET AL) 20 October 1998 (1998-10-20)<br>* column 5, line 23 - column 6, line 38 * | 1,6,7 | |

**TECHNICAL FIELDS SEARCHED (Int.Cl.7)**

H01S
G01J

The present search report has been drawn up for all claims

| Place of search | Date of completion of the search | Examiner |
|---|---|---|
| MUNICH | 26 March 2002 | Jacquin, J |

**ANNEX TO THE EUROPEAN SEARCH REPORT
ON EUROPEAN PATENT APPLICATION NO.** EP 01 30 9898

This annex lists the patent family members relating to the patent documents cited in the above-mentioned European search report.
The members are as contained in the European Patent Office EDP file on
The European Patent Office is in no way liable for these particulars which are merely given for the purpose of information.

26-03-2002

| Patent document cited in search report | | Publication date | Patent family member(s) | | Publication date |
|---|---|---|---|---|---|
| WO 0177626 | A | 18-10-2001 | AU | 5315401 A | 23-10-2001 |
| | | | WO | 0177626 A2 | 18-10-2001 |
| EP 0911621 | A | 28-04-1999 | JP | 11122176 A | 30-04-1999 |
| | | | EP | 0911621 A2 | 28-04-1999 |
| | | | US | 5896201 A | 20-04-1999 |
| WO 9904466 | A | 28-01-1999 | DE | 19881180 T0 | 02-09-1999 |
| | | | WO | 9904466 A1 | 28-01-1999 |
| | | | GB | 2332086 A ,B | 09-06-1999 |
| | | | US | 6345060 B1 | 05-02-2002 |
| DE 4429748 | A | 16-03-1995 | ES | 2079282 A2 | 01-01-1996 |
| | | | DE | 4429748 A1 | 16-03-1995 |
| GB 2353858 | A | 07-03-2001 | AU | 6857700 A | 26-03-2001 |
| | | | WO | 0116569 A1 | 08-03-2001 |
| US 5825792 | A | 20-10-1998 | CA | 2209558 A1 | 11-01-1998 |
| | | | EP | 0818859 A1 | 14-01-1998 |
| | | | JP | 10079723 A | 24-03-1998 |

EPO FORM P0459

For more details about this annex : see Official Journal of the European Patent Office, No. 12/82